# EUROPÄISCHE PATENTSCHRIFT

(11) **EP 2 341 623 B1**
(45) Veröffentlichungstag und Bekanntmachung des Hinweises auf die Patenterteilung: **27.04.2016**
(21) Anmeldenummer: 10194817.2
(22) Anmeldetag: 14.12.2010
(51) Int. Cl.: H03K 17/955, H03K 17/96

(54) **Berührungsempfindlicher Taster**
Touch-sensitive sensor
Bouton tactile

(30) Priorität: 22.12.2009 DE 102009055143
(43) Veröffentlichungstag der Anmeldung: 06.07.2011
(73) Patentinhaber: BSH Hausgeräte GmbH, 81739 München (DE)
(72) Erfinder: Wohlstreicher, Franz, 93197 Zeitlarn (DE)

(56) Entgegenhaltungen:
- WO-A1-00/44018
- DE-A1-102007 000 713
- US-A1- 2007 046 299
- US-A1- 2007 183 182

## Beschreibung

Die Erfindung betrifft eine Schaltungsanordnung, insbesondere einen bzw. für einen berührungsempfindlichen Taster sowie ein Haushaltsgerät mit einem solchen berührungsempfindlichen Taster als auch ein Verfahren zum Betrieb der Schaltungsanordnung.

In zunehmendem Maße werden zur Bedienung von Geräten berührungsempfindliche Sensoren (für berührungsempfindliche Taster bzw. Berührtaster) verwendet.

Hierdurch können mechanische Tasten ersetzt werden, die z.B. Umgebungseinflüssen ausgesetzt sind und deren Funktion durch Verschmutzung beeinträchtigt sein kann. Beispielsweise kann eine solche Verschmutzung bei einem Küchengerät durch überlaufende Flüssigkeiten oder durch Dämpfe erfolgen. Darüber hinaus haben mechanische Tasten den Nachteil, dass sie einem natürlichen Verschleiß unterliegen. Ferner gibt es häufig in Geräten Designvorgaben, die aus optischen Gründen keine mechanischen Tasten zulassen.

Aus US 2007/0183182 A1 ist ein kapazitiver differentieller Einklemmschutz-Sensor bekannt. Aus WO 00/44018 A1 ist ein kapazitiver Messwandler und mit Anordnung bekannt. DE 10 2007 000 713 A1 betrifft ein Kapazitätserfassungsgerät.

Somit ist es ein Ziel, Tasten mit mechanischen Kontakten und fühlbarem Hub durch elektronische Sensorflächen zu ersetzen, die durch eine bloße Berührung aktiviert werden können.

Die meisten elektronischen Sensorflächen basieren auf der Messung einer Kapazität und deren Änderung bei Berührung einer isolierenden Sensorfläche durch einen Finger der bedienenden Person gegen Erde. Der Finger kann also eine vorgegebene Fläche auf einem Isolator berühren, hinter dem eine leitende Fläche in Form einer Kondensatorplatte vorgesehen ist. Die andere Platte des Kondensators wird durch den Finger gebildet, der über den Körper und den Schutzleiter (PE, protective earth) mit der Masse der Elektronik verbunden ist. Messtechnisch erfolgt mit der Berührung durch den Finger eine Zunahme der Kapazität von der Sensorfläche zur Erde, elektrisch also von der Sensorfläche über den Körper und den Schutzleiter zur Masse der auswertenden Elektronik.

Der Kapazitätszuwachs durch die Berührung der Sensorfläche mit dem Finger beträgt lediglich ca. ein Picofarad.

Einerseits ist es günstig, die Grundkapazität, welche sich durch den Aufbau der gesamten Anordnung ergibt, möglichst gering zu halten, um noch einen ausreichend großen Signalhub durch die Berührung des Fingers zu erhalten und geeignet auswerten zu können. Andererseits ist es jedoch schwierig, den Aufbau der gesamten Anordnung so auszulegen, dass parasitäre Kapazitäten in einer Größenordnung kleiner als 5 pF auftreten. Üblich sind z.B. parasitäre Kapazitäten von ca. 5 pF bis 10 pF. Somit ergibt dies also bei der Berührung des Fingers einen maximalen Signalhub von 10% bis 20% des Grundpegels. Ein solch geringer Signalhub erfordert zur Auswertung einen Mikrokontroller und einen Analog-Digital-Umsetzer.

Durch den geringen und stark limitierten Signalhub ist eine Auswertung der Berührung durch den Finger - auch unter Ausnutzung des Mikrokontrollers - aufwändig und schwierig. Außerdem ist eine Fehlbedienung nicht auszuschließen. Insbesondere ist es von Nachteil, dass eine Bedienung des Nutzers nicht als solche erkannt wird; dies reduziert die Benutzerakzeptanz, da ja auch kein Druckpunkt mehr vorhanden ist, der dem Nutzer haptische Rückmeldung über die Bedienung ermöglichen würde.

Wird das Signal zusätzlich mit Störungen beaufschlagt, ist die Auswertung der Berührung nahezu unmöglich.

Die Aufgabe der Erfindung besteht darin, die vorstehend genannten Nachteile zu vermeiden und insbesondere eine Lösung anzugeben, die eine Erkennung einer Aktivierung eines berührungsempfindlichen Tasters oder Schalters mit hoher Sicherheit ermöglicht.

Diese Aufgabe wird gemäß den Merkmalen des unabhängigen Anspruchs 1 gelöst. Weiterbildungen der Erfindung ergeben sich auch aus den abhängigen Ansprüchen.

Zur Lösung der Aufgabe wird eine Schaltungsanordnung angegeben, die als ein berührungsempfindlicher Taster ausgestaltet ist oder einen solchen umfasst, gemäß den Merkmalen des unabhängigen Anspruchs 1.

Hierbei ist es von Vorteil, dass parasitäre Kapazitäten bei der Messung eines Signalhubs des berührungsempfindlichen Tasters weitgehend kompensiert werden können.

Die erste und die zweite Sensorfläche sind so nebeneinander angeordnet, dass sie eine Sensorkapazität darstellen.

Hierbei sei angemerkt, dass es sich bei dem berührungsempfindlichen Taster um eine Tast- oder Schaltfunktion handeln kann, die insbesondere durch Berührung des Isolators oberhalb der beiden Sensorflächen ausgelöst werden kann. Durch die Berührung, z.B. mit einem Finger, wird die Sensorkapazität zwischen der ersten Sensorfläche und der zweiten Sensorfläche verändert. Die Veränderung wird entsprechend ausgewertet und z.B. als Aktivierung des berührungsempfindlichen Tasters interpretiert.

Der Aufbau erlaubt weiterhin eine hohe Kanaltrennung wenn mehrere berührungsempfindliche Taster nebeneinander angeordnet sind.

Eine Weiterbildung ist es, dass die zweite Sensorfläche zumindest zeitweise schwebend, also ohne Massebezug, mit dem Eingang des Messverstärkers verbunden ist.

Eine andere Weiterbildung ist es, dass die erste Sensorfläche abwechselnd mit einer Versorgungsspannung und mit Masse verbunden ist.

Die abwechselnde Anbindung der Sensorflächen kann über einen elektronisch gesteuerten Umschalter erfolgen.

Insbesondere ist es eine Weiterbildung, dass das Wechselsignal zur Umschaltung der ersten Sensorfläche mittels eines Rechteckgenerators erzeugbar ist.

Auch ist es eine Weiterbildung, dass der Rechteckgenerator einen Umschalter steuert, der die Verbindung der zweiten Sensorfläche umschaltet zwischen dem Eingang des Messverstärkers und Masse.

Hierdurch kann effizient eine Verbindung der zweiten Sensorfläche mit dem Eingang des Messverstärkers ohne Massebezug erreicht werden (Prinzip der virtuellen Masse).

Ferner ist es eine Weiterbildung, dass die zweite Sensorfläche über einen gesteuerten Schalter zumindest zeitweise mit dem Eingang des Messverstärkers verbunden ist, so dass entweder ein Ladestrom oder ein Entladestrom des die beiden Sensorflächen umfassenden Messkondensators an den Messverstärker geleitet wird.

Insbesondere ist es von Vorteil, den Entladestrom einzusetzen und als Eingang den invertierenden Eingang des Messverstärkers zu verwenden. In diesem Fall ist das Ausgangssignal des Messverstärkers positiv und der Messverstärker kann damit an einer positiven Versorgungsspannung betrieben werden.

Im Rahmen einer zusätzlichen Weiterbildung ist der berührungsempfindliche Taster durch Berührung des Isolators oberhalb der beiden Sensorflächen aktivierbar.

Insbesondere kann eine derartige Aktivierung des berührungsempfindlichen Tasters anhand eines abnehmenden Ausgangssignals des Messverstärkers angezeigt ("lowaktiv") werden.

Eine nächste Weiterbildung besteht darin, dass die Sensorflächen mit einem Flachbandkabel angeschlossen sind, wobei zumindest zwischen zwei Anschlüssen der Sensorflächen mindestens eine Masseleitung vorgesehen ist.

Hierbei ist es von Vorteil, dass hierdurch die Erkennung des Signalhubs bei Aktivierung des berührungsempfindlichen Tasters zusätzlich verbessert werden kann, weil parasitäre Kapazitäten nach Masse mit dem vorliegenden Ansatz (weitgehend) kompensiert werden.

Eine Ausgestaltung eines Beispiels ist es, dass
- ein Ausgang des Messverstärkers über einen A/D-Wandler mit einem Mikrokontroller verbunden ist,
- der Mikrokontroller über einen D/A-Wandler oder über ein von dem Mikrokontroller angesteuertes Digitalpotenziometer mit dem Eingang des Messverstärkers verbunden ist,
- wobei der Mikrokontroller im Ruhezustand das Signal am Eingang des A/D-Wandlers auf einen Wert unterhalb eines vorgegebenen Auslösewerts einstellt.

Hierbei kennzeichnet der Ruhezustand den Zustand, in dem die Sensorflächen nicht berührt werden, also keine Aktivierung des berührungsempfindlichen Tasters erfolgt.

Somit ist es von Vorteil, dass über den Mikrokontroller die Aktivierungsschwelle des berührungsempfindlichen Tasters so eingestellt wird, dass bei entsprechender Aktivierung ein deutlicher Signalhub zustande kommt und ausgewertet werden kann.

Alternativ kann anstelle des D/A-Wandlers eine geschaltete Kapazität mit einem Umschalter eingesetzt wird. In diesem Fall könnte von dem Mikrokontroller ein schneller Taktausgang pro Sensor bereitgestellt werden. Der rückgekoppelte Abgleichstrom in den Messverstärker wäre dann von der Spannung, dem Kapazitätswert und der Schaltfrequenz abhängig.

Ein alternatives Beispiel besteht darin, dass
- ein Ausgang des Messverstärkers über einen ersten Komparator mit einem Mikrokontroller verbunden ist, wobei anhand eines Schwellwerts des ersten Komparators dem Mikrokontroller das Ende eines Abgleichvorgangs anzeigbar ist,
- der Ausgang des Messverstärkers über einen zweiten Komparator mit dem Mikrokontroller verbunden ist, wobei der zweite Komparator bei Erreichen einer Schaltschwelle eine Aktivierung des berührungsempfindlichen Tasters dem Mikrokontroller anzeigt,
- der Mikrokontroller über einen D/A-Wandler oder über ein von dem Mikrokontroller angesteuertes Digitalpotenziometer mit dem Eingang des Messverstärkers verbunden ist.

Insbesondere wird dem Mikrokontroller bei Überschreiten des Schwellwerts des ersten Komparators angezeigt, dass der Abgleichvorgang beendet ist. Somit kann nach abgeschlossenem Abgleichvorgang der Signalhub des berührungsempfindlichen Tasters ermittelt und ausgewertet werden.

Hierbei ist es von Vorteil, dass der Messverstärker lediglich auf den Schwellwert des ersten Komparators abgeglichen wird.

Auch ist es eine Weiterbildung, dass der zweite Komparator eine Hysterese aufweist und bei Erreichen einer niedrigen Schaltschwelle eine Aktivierung des berührungsempfindlichen Tasters dem Mikrokontroller anzeigt.

So ist es von Vorteil, dass der A/D-Wandler eingespart werden kann und/oder anstelle des D/A-Wandlers ein von dem Mikrokontroller angesteuertes Digitalpotenziometer einsetzbar ist.

Eine Alternative besteht darin, die beiden Komparatoren über eine Exklusive-Oder-Funktion zu einem Fensterkomparator zu verbinden. Mittels der auf dem Mikrokontroller ablaufenden Software kann erreicht werden, dass nach beendetem Schaltungsabgleich ein anderes Programm gestartet wird. Kippt der zweite Komparator aufgrund der Aktivierung des berührungsempfindlichen Tasters, so kippt der Exklusiv-Oder-Ausgang zurück, was von diesem Programm als Tastendruck interpretiert werden kann. So könnte an dem Mikrokontroller für jeden Berührtaster ein Eingang eingespart werden, wenn die Anzahl der Eingänge an dem Mikrokontroller sonst nicht ausreichen würde.

Die Verwendung des Balanceverstärkers ermöglicht eine Auswertung des Signalhubs des berührungsempfindlichen Tasters ganz ohne Mikrokontroller oder A/D-D/A-Wandlung.

Eine Weiterbildung besteht darin, dass der Balanceverstärker als ein Integrator ausgeführt ist, der eine wesentlich längere Integrationszeit aufweist als der Messverstärker.

Hierdurch kann erreicht werden, dass anhand des Balanceverstärkers nicht solche Schwankungen ausgeregelt werden, die auf der Aktivierung des berührungsempfindlichen Tasters beruhen.

Insbesondere kann zur Auswertung des durch die Berührung der Sensorfläche hervorgerufenen Signalhubs die Integrationszeit des Balanceverstärkers länger sein als ein Einlesezyklus einer nachgeschalteten signalverarbeitenden Logik (z.B. eines Mikrokontrollers).

berührungsempfindlichen Tasters gespeichert wird, insbesondere mittels eines Flipflops.

Dies hat den Vorteil, dass eine Aktivierung des berührungsempfindlichen Tasters von einer nachgeschalteten signalverarbeitenden Logik erkannt werden kann. Beispielsweise kann nach dem Einlesen der Aktivierung von der signalverarbeitenden Logik das Flipflop zurückgesetzt werden.

Auch ist es eine Ausgestaltung, dass eine Dauer der Betätigung des berührungsempfindlichen Tasters mittels eines Aktivierungssignals und eines Überschwingens im Ausgangssignal des Messverstärkers ermittelbar ist.

Hierzu kann ein Komparator mit einer Hysterese am Ausgang des Messverstärkers angeordnet sein, wobei die obere Schwelle des Komparators oberhalb des Ruhepegels liegt. Wird der berührungsempfindliche Taster aktiviert, geht das Signal des Messverstärkers unter die untere Hysterese-Schwelle des Komparators und der Komparator kippt und bleibt in dieser Stellung, da der Balanceverstärker nur bis zum Ruhepegel ausregelt. Erst wenn der Finger von der Sensorfläche genommen wird, wird durch den Überschwinger die obere Schaltschwelle des Komparators überschritten und der Komparator kippt in seinen Ruhezustand zurück. Dadurch kann ein nachgeschalteter Mikrokontroller die Dauer der Tastenbetätigung ermitteln.

Eine Weiterbildung besteht darin, dass der berührungsempfindliche Taster in einem Haushaltsgerät, insbesondere einem Küchengerät, insbesondere einem Herd einsetzbar ist.

Die oben genannte Aufgabe wird auch gelöst anhand eines Haushaltsgeräts umfassend mindestens einen berührungsempfindlichen Taster wie hierin beschrieben.

Ausführungsbeispiele und Beispiele werden nachfolgend anhand der Zeichnungen dargestellt und erläutert.

Es zeigen:
Fig.1 ein schematisches Ersatzschaltbild zur Realisierung eines effizienten berührungsempfindlichen Tasters;
Fig.2 ein schematisches Blockschaltbild basierend auf Fig.1 mit einer nachgeschalteten Mikrokontrollersteuerung;
Fig.3 ein schematisches Blockschaltbild basierend auf Fig.1 mit einer alternativen nachgeschalteten Mikrokontrollersteuerung;
Fig.4 ein schematisches Blockschaltbild basierend auf Fig.1 mit einer
   Auswertung anhand eines Balanceverstärkers gemäß eines Ausführungsbeispiels;
Fig.5 ein Ausführungsbeispiel einer Schaltung für eine solche Auswertung mittels des erwähnten Balanceverstärkers in Kombination mit dem Messverstärker.

Es wird insbesondere eine Lösung angegeben, bei der parasitäre Kapazitäten bei der Messung eines Signals eines Berührtasters weitgehend ausgeschlossen werden können.

Hierbei sei angemerkt, dass es sich bei dem Berührtaster um einen berührungsempfindlichen Sensor handeln kann, anhand dessen eine elektrische Tastfunktion und/oder eine elektrische Schaltfunktion ermöglicht wird.

Beispielsweise sind die parasitären Kapazitäten hauptsächlich gegen Masse geschaltet; das gleiche gilt für die Signalkapazität bei der Berührung (also die Signalkapazität des Fingers).

Insbesondere wird vorgeschlagen, eine separate Kapazität in einem Messzweig einer auswertenden Elektronik durch Berührung mit einem Finger zu verändern. Demgemäß werden zwei Sensorflächen vorgeschlagen, die auf der Rückseite einer durch den Bediener zu berührenden Fläche auf einem Isolierträger nahe zueinander angeordnet sind.
Diese beiden Sensorflächen bilden also auch ohne Berührung der zu berührenden Fläche (also des entsprechenden Bereichs des Isoliermaterials) mit dem Finger einerseits über das Isoliermaterial und andererseits über die Luft bereits einen Kondensator. Dieser Kondensator wird im Folgenden auch als Messkondensator, Messkapazität oder Sensorkapazität bezeichnet.

Vorzugsweise wird ein Ladestrom durch die Messkapazität gemessen, Ladeströme durch parasitäre Kapazitäten werden jedoch an einem Messverstärker vorbeigeleitet.

Zur Erzeugung eines zu messenden Stromflusses durch den Messverstärker wird der Messkondensator ständig umgeladen. Die eine Sensorfläche des Messkondensators kann also fortwährend an eine Referenzspannungsquelle angeschlossen und von dieser getrennt werden, während die andere Sensorfläche des Messkondensators schwebend (ohne Massebezug) mit dem Eingang des Messverstärkers verbunden ist.

Dies hat einen pulsförmigen Strom zur Folge, der in eine geglättete Ausgangsspannung zur Auswertung gewandelt wird. Zu diesem Zweck wird der Messverstärker als ein Integrator (d.h. ein Strom- oder Ladungs- zu Spannungswandler) eingesetzt.

Würde man nur eine Kondensatorplatte zwischen der Versorgungsspannung und Masse hin- und herschalten, um den Kondensator periodisch aufzuladen und zu entladen, wäre der mittlere Stromfluss Null, das Ausgangssignal des Integrators ebenfalls. Daher wird nur eine Stromrichtung (entweder der Ladestrom oder der Entladestrom) in den Messverstärker geleitet.

Dies kann dadurch erreicht werden, dass ein weiterer Umschalter zwischen der zweiten Kondensatorplatte und dem Eingang des Messverstärkers vorgesehen ist. Hierbei ist es von Vorteil, den Strom aus dem invertierenden Eingang herausfließen zu lassen, also nur den Entladestrom mit dem Eingang des Messverstärkers zu verbinden. Das Ausgangssignal des Messverstärkers ist dann positiv, was den Betrieb des Messverstärkers an einer positiven Versorgungsspannung ermöglicht.

Der aus dem Messverstärker herausfließende Strom ist von der Spannung, dem Kapazitätswert und der Schaltfrequenz abhängig.

Legt ein Nutzer seinen Finger auf die vorgesehene Fläche des isolierenden Trägers, hinter dem sich die beiden die Sensorkapazität bildenden Flächen befinden, so erhöht sich bei beiden Flächen deren Kapazität gegen Erde; diese Kapazitäten werden aber kompensiert, wie nachfolgend noch ausgeführt wird.

Der Finger mit seiner guten (inneren) Leitfähigkeit (Blut besteht aus gut leitenden Ionen) und seinem relativ großen Querschnitt bildet eine leitfähige Brücke über die beiden Sensorflächen. Es entsteht also über den Isolierträger und die Haut eine Reihenschaltung von zwei Kapazitäten mit der Folge einer Kapazitätsabnahme.

Die Abnahme der Kapazität führt zur Abnahme des Ausgangssignals des Messverstärkers, die Schaltung ist sozusagen "low-aktiv", also die Aktivierung wird mit einem abnehmenden Ausgangssignal des Messverstärkers angezeigt.

Da auch Kapazitäten zu benachbarten Sensoren keinen Einfluss auf das Messsignal haben, und für jeden Sensor eine eigene Schaltung erforderlich ist (Sensoren sind an keiner Busleitung angeschlossen) folgt daraus eine große Unempfindlichkeit gegenüber benachbarten Sensorflächen und damit eine deutliche Kanaltrennung.

Sind die Zuleitungen zu den Sensorflächen eng beieinander ausgeführt, erhöhen sie die Sensor-Ruhekapazität, tragen aber nicht zum Signalhub bei Berührung durch den Finger bei. Zusätzlich könnte die Verstärkung des Messverstärkers erhöht werden.

Alternativ kann ein Flachbandkabel eingesetzt werden, das zwischen den Sensorleitungen einfach Masseleitungen aufweist. Dadurch werden parasitäre Kapazitäten nach Masse gebildet. Derartige parasitäre Kapazitäten bleiben bei dem hier beschriebenen Verfahren jedoch (weitgehend) unberücksichtigt und verfälschen somit das Messergebnis nicht.

Als elektronischer Umschalter der Betriebsspannung nach Masse kann auch ein Ausgang eines Rechteckgenerators vorgesehen sein. Vorzugsweise hat der Rechteckgenerator einen kleinen Innenwiderstand.

Das Signal des Rechteckgenerators kann dann auch benutzt werden, um den elektronischen Umschalter zwischen der zweiten Sensorfläche und dem Messverstärkereingang zu steuern.

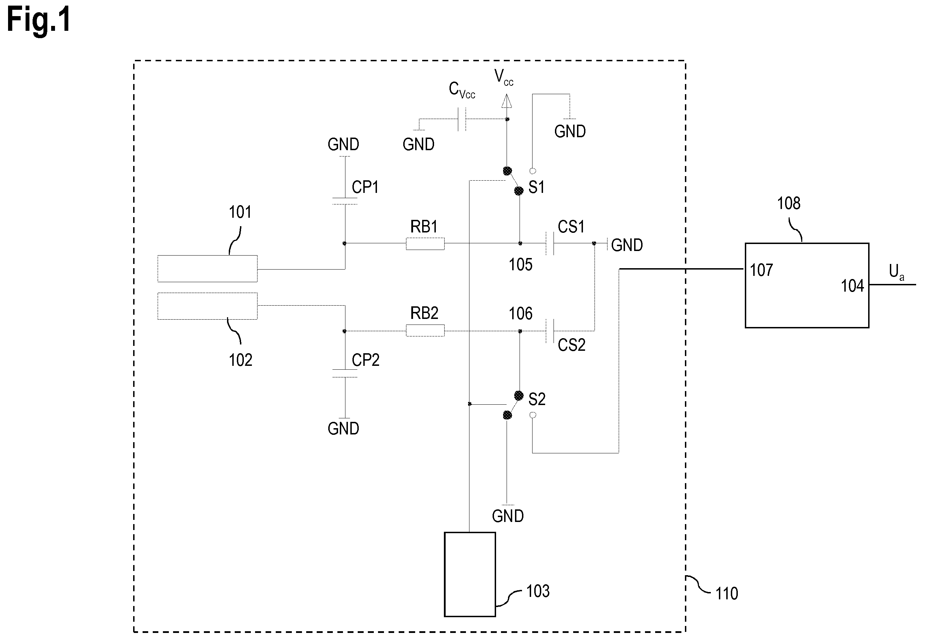

**Fig.1** zeigt ein schematisches Ersatzschaltbild zur Realisierung eines effizienten berührungsempfindlichen Tasters mit parasitären Bauteilen.

Eine Sensorfläche 101 und eine Sensorfläche 102 sind auf der Rückseite einer durch den Bediener zu berührenden Fläche auf einem Isolierträger nahe zueinander angeordnet.

Bei einer praktischen Realisierung kann sich beispielsweise das gezeigte Ersatzschaltbild mit parasitären Bauteilen der Schaltung und des Schalters ergeben.

Die Sensorfläche 101 ist über eine Kondensator CP1 mit Masse verbunden. Weiterhin ist die Sensorfläche 101 über eine Reihenschaltung aus einem Widerstand RB1 und einem Kondensator CS1 mit Masse verbunden, wobei der Mittenabgriff dieser Reihenschaltung als Knoten 105 bezeichnet wird und mit einem Umschalter S1 verbunden ist. Durch den Umschalter S1 kann der Knoten 105 entweder mit einer Versorgungsspannung V_{cc} oder mit Masse verbunden werden. Zwischen der Versorgungsspannung V_{cc} und Masse ist ein Kondensator C_{Vcc} angeordnet.

Die Sensorfläche 102 ist über einen Kondensator CP2 mit Masse verbunden. Weiterhin ist die Sensorfläche 102 über eine Reihenschaltung aus einem Widerstand RB2 und einem Kondensator CS2 mit Masse verbunden, wobei der Mittenabgriff dieser Reihenschaltung als Knoten 106 bezeichnet wird und mit einem Umschalter S2 verbunden ist. Durch den Umschalter S2 kann der Knoten 106 entweder mit Masse oder mit einem Eingang 107 eines Messverstärkers 108 verbunden werden.

Bei dem Messverstärker 108 handelt es sich vorzugsweise um einen Strom-/Landungs-Spannungswandler. Der Messverstärker 108 stellt an einem Ausgang 104 eine Ausgangsspannung Ua bereit.

Die Umschalter S1 und S2 werden durch eine digitale Steuerschaltung 103, z.B. einen Rechteckgenerator, angesteuert.

Der Teil der Schaltung von Fig.1 bis auf den Messverstärker 108 wird zur späteren Bezugnahme als ein Schaltungsblock 110 bezeichnet.

Beispielhaft können sich die folgenden Werte ergeben: CP1=CP2=10pF; RB1=RB2=20k; C_{Vcc}=1µF; CS1=CS2=1nF.

Die Steuerschaltung 103 bewirkt, dass die beiden Umschalter S1, S2 zunächst in der in Fig.1 gezeigten Position sind (Umschalter S1: Verbindung der Versorgungsspannung V_{cc} mit dem Knoten 105; Umschalter S2: Verbindung des Knotens 106 mit Masse). So wird die Sensorkapazität (Kapazität zwischen den Sensorflächen 101, 102) über die Leiterbahnwiderstände RB1 und RB2 und über die parasitären Kapazitäten an der Versorgungsspannung Vcc aufgeladen.

Der Ladestrom der parasitären Kapazitäten CS1 (Schalterkapazität) und CP1 (parasitäre Kapazitäten der Schaltung) fließt an den Sensorflächen vorbei direkt nach Masse. Der Ladestrom fließt damit nicht durch den Sensor und beeinflusst bzw. verfälscht die Sensorkapazität nicht.

Da der Umschalter S2 in dieser Ausgangsstellung mit Masse verbunden ist, werden die parasitäre Kapazitäten CS2, CP2 an der Sensorfläche 102 gegen Masse gar nicht erst aufgeladen und haben somit ebenfalls keinen Einfluss auf den Messstrom.

Insbesondere ist es bei der Ansteuerung der Umschalter S1, S2 von Vorteil, dass die geschlossenen Schalter zuerst öffnen, erst dann dürfen die beiden anderen Schalter schließen; dies ist von Vorteil, wenn einzelne Schalter (z.B. Transistoren, Mosfets) zum Umschalten eingesetzt werden.

Schalten in einem zweiten Zyklus beide Umschalter S1, S2, so liegt die Sensorfläche 101 an Masse und die Sensorfläche 102 ist mit dem negativen Eingang 107 des Messverstärkers 108 verbunden.

Der Messverstärker 108 regelt seinen Ausgang 104 so, dass die Spannungsdifferenz der Eingänge Null ist. Liegt der positive Eingang des Messverstärkers 108 an Masse (nicht in Fig.1 dargestellt), so steigt die Spannung Uₐ an dem Ausgang 104 des Messverstärkers 108 soweit an, bis die Spannung am invertierenden Eingang 107 ebenfalls Null ist. Die Sensorfläche 102 bleibt also auf Massepotenzial (Prinzip der virtuellen Masse).

Insbesondere können als Messverstärker 108 Operationsverstärker mit Gleichtaktbereich bis Masse, also solche mit PNP- oder P-Kanal-Struktur an den Eingängen, eingesetzt werden.

Signaltechnisch liegt auch die Sensorfläche 101 auf Masse, da der Innenwiderstand der Versorgungsspannung V_{cc} Null ist.

Die Schaltung könnte so dimensioniert werden, dass durch einen Gegenkopplungswiderstand der Messverstärker 108 im Gleichgewicht ist. Dies erfordert einen verhältnismäßig niedrigen Gegenkopplungswiderstand, da dieser auch Leckströme in den Eingang 107 des Messverstärkers 108 sowie einen Grundpegel kompensieren sollte. Somit würden sich eine geringe Verstärkung und damit ein kleiner, schwierig auszuwertender Signalhub bei Betätigung der Sensorflächen ergeben. Auch gäbe es keine Möglichkeit zu bestimmen, wo ein Ruhepegel (als high-Pegel) zu liegen käme. Verbunden mit dem kleinen Signalhub würde ein Aktivierungssignal (low-Pegel) kaum zustande kommen.

Um möglichst viel Ladung in die Sensorkapazität zu bekommen, ist diese mit einer möglichst hohen Spannung zu laden. Der Ruhepegel kann sich daher je nach Toleranz der Bauteile bei einer höheren Spannung als einer zulässigen Eingangsspannung eines signalverarbeitenden nachgeschalteten Mikrokontrollers einstellen.

Ein großer Vorteil der hier vorgestellten Lösung besteht darin, den Messverstärker 108 so zu dimensionieren, dass durch die Bedienung (Berührung mit dem Finger) ein großer Signalhub erreicht wird, den man direkt von der nachgeschalteten auswertenden Logik als Digitalsignal nutzen kann.

Die Schaltung gemäß Fig.1 wird demnach vorzugsweise ergänzt durch
- einen Balanceverstärkers mit einem verhältnismäßig niedrigem Rückkopplungswiderstand, der die Schaltung unabhängig von dem Messverstärker auf einen definierten high-Pegel regelt oder
- einen Mikrokontroller, der das Ausgangssignal des Messverstärkers auswertet.

### Auswertung mittels Mikrokontrollers

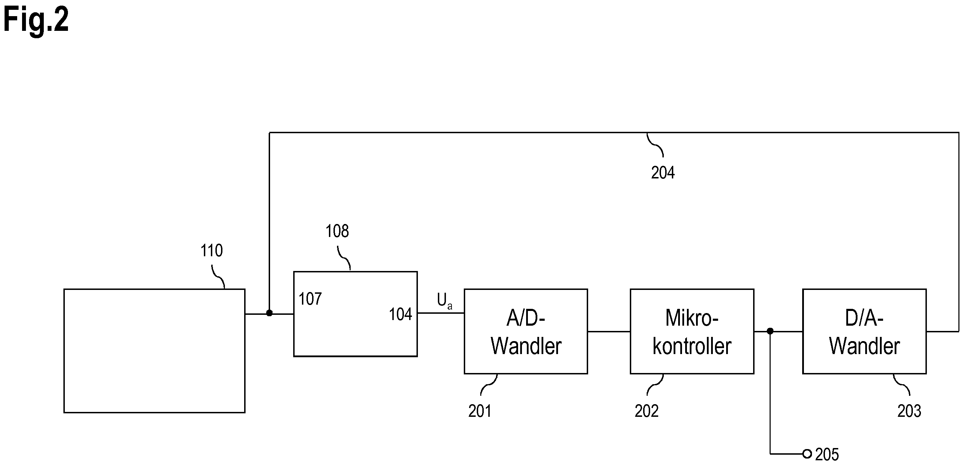

**Fig.2** zeigt ein schematisches Blockschaltbild basierend auf Fig.1 mit einer nachgeschalteten Mikrokontrollersteuerung.

Der bereits in Fig.1 gezeigte und beschriebene Schaltungsblock 110 ist mit dem Messverstärker 108 verbunden. Der Ausgang 104 des Messverstärkers 108 ist über einen A/D-Wandler 201 mit einem Mikrokontroller 202 verbunden. Am Ausgang des Mikrokontrollers 202 wird ein Ausgangssignal 205 bereitgestellt. Der Mikrokontroller 202 ist ferner mit einem D/A-Wandler 103 verbunden, dessen Ausgang über eine Verbindung 204 mit dem Eingang 107 des Messverstärkers 108 gekoppelt ist.

Somit wird das Signal am Ausgang 104 des Messverstärkers 108 mittels des A/D-Wandlers 201 gemessen und über den Mikrokontroller 202 und den D/A-Wandler 203 das Signal im Ruhezustand auf einen Wert kurz unter einen vorgegebenen Maximalwert des Eingangs des A/D-Wandlers eingestellt. In dieser Einstellung wird durch die Berührung der Sensorflächen mit dem Finger ein großer Signalhub erreicht.

Der Aufwand für die in Fig.2 gezeigte Schaltung könnte reduziert werden, indem anstelle des D/A-Wandlers 203 eine geschaltete Kapazität mit einem Umschalter eingesetzt wird. In diesem Fall könnte von dem Mikrokontroller 202 ein schneller Taktausgang pro Sensor bereitgestellt werden. Der mittels Rückkopplung 204 eingespeiste Strom wäre dann von der Spannung, dem Kapazitätswert und der Schaltfrequenz abhängig.

Eine weitere Möglichkeit besteht darin, den D/A-Wandler 203 durch ein Digitalpotenziometer zu ersetzen.

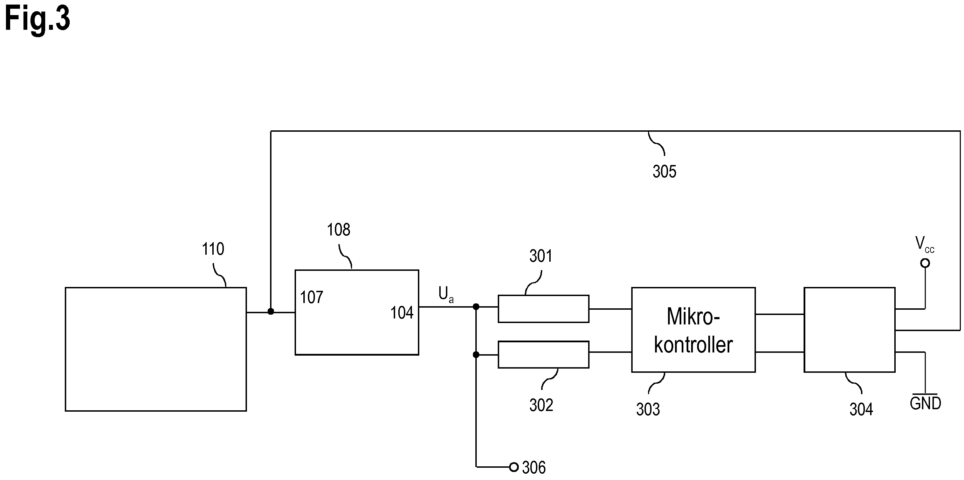

**Fig.3** zeigt ein schematisches Blockschaltbild basierend auf Fig.1 mit einer alternativen nachgeschalteten Mikrokontrollersteuerung.

Der Schaltungsblock 110 gemäß Fig.1 ist mit dem Messverstärker 108 verbunden. Der Ausgang 104 des Messverstärkers 108 ist mit zwei Komparatoren 301, 302 verbunden, wobei die Komparatoren 301, 302 ausgangsseitig mit einem Mikrokontroller 303 verbunden sind. Der Mikrokontroller 303 ist ferner mit einem Digitalpotenziometer 304 verbunden, wobei das Digitalpotenziometer 304 über eine Verbindung 305 mit dem Eingang 107 des Messverstärkers 108 gekoppelt ist.

Über den Ausgang 104 des Messverstärkers 108 wird ein Ausgangssignal 306 bereit gestellt.

Für die Erkennung des Abgleichpunktes wird der Komparator 301 mit einem festen Schaltpunkt (also ohne Hysterese) eingesetzt, um der Software in dem Mikrokontroller 303 ein Signal für die Beendigung des Abgleichvorgangs bereitzustellen.

Digitalpotentiometer 304 ein. Mit einer Datenschnittstelle zur Einstellung des Digitalpotentiometers 304 können mit ausreichend feiner Abstimmung verschiedene Werte zwischen 0 und V_{cc} über die Leitung 305 an den Eingang 107 des Messverstärkers 108 gelegt werden.

Der Komparator 302 wird zur Auswertung der Bedienung der Sensorflächen eingesetzt: Hierzu weist der Komparator 302 eine Hysterese auf, wobei der Komparator 302 bei einer niedrigeren Schaltschwelle durch die Berührung des Sensors (low-Signal am Ausgang 107 des Messverstärkers 108) kippt und somit dem Schaltvorgang dem Mikrokontroller 303 anzeigt.

Hierbei ist es von Vorteil, dass der A/D-Wandler gemäß Fig.2 eingespart werden kann; auch ist der Messverstärker vorteilhaft lediglich auf den Schaltpunkt des Komparators 301 abzugleichen.

Auch ist es möglich, die beiden Komparatoren 301, 302 über eine Exklusive-Oder-Funktion zu einem Fensterkomparator zu verbinden. Mittels der auf dem Mikrokontroller ablaufenden Software kann erreicht werden, dass nach beendetem Schaltungsabgleich ein anderes Programm gestartet wird. Kippt dann der zweite Komparator aufgrund der Tastenbedienung, so kippt der Exklusiv-Oder-Ausgang zurück, was dann von diesem Programm als Tastendruck interpretiert werden kann. So könnte an dem Mikrokontroller für jeden Berührtaster ein Eingang eingespart werden, wenn die Anzahl der Eingänge an dem Mikrokontroller sonst nicht ausreichen würde.

### Auswertung mittels Balanceverstärkers

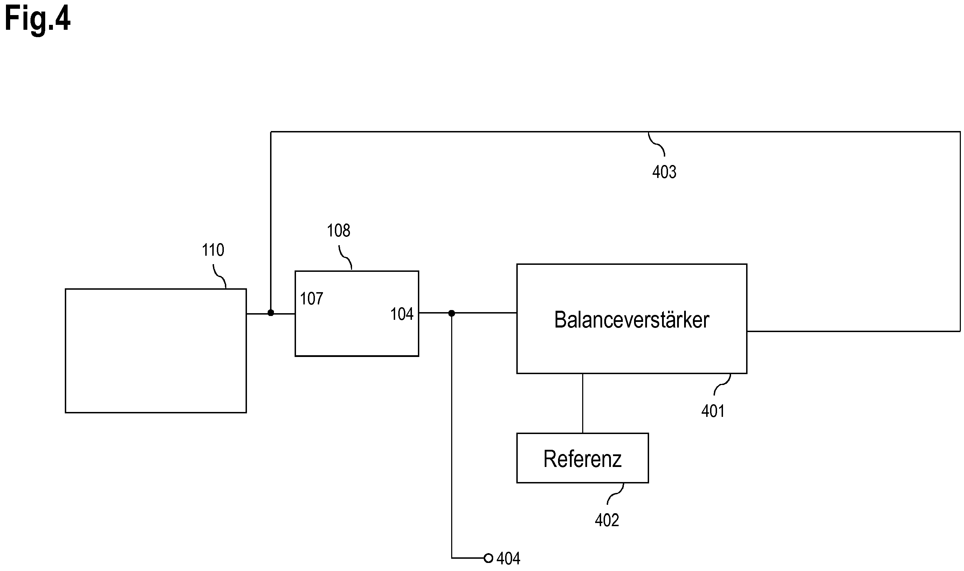

**Fig.4** zeigt ein schematisches Blockschaltbild basierend auf Fig.1 mit einer Auswertung anhand eines Balanceverstärkers 401 gemäß eines Ausführungsbeispiels.

Der Schaltungsblock 110 gemäß Fig.1 ist mit dem Messverstärker 108 verbunden. Der Ausgang 104 des Messverstärkers 108 ist mit dem Balanceverstärker 401 verbunden, wobei der Balanceverstärker 401 mittels einer Referenz 402 gespeist wird. Der Ausgang des Balanceverstärkers 401 ist über eine Verbindung 403 mit dem Eingang 107 des Messverstärkers 108 gekoppelt.

Über den Ausgang 104 des Messverstärkers 108 wird ein Ausgangssignal 404 bereit gestellt.

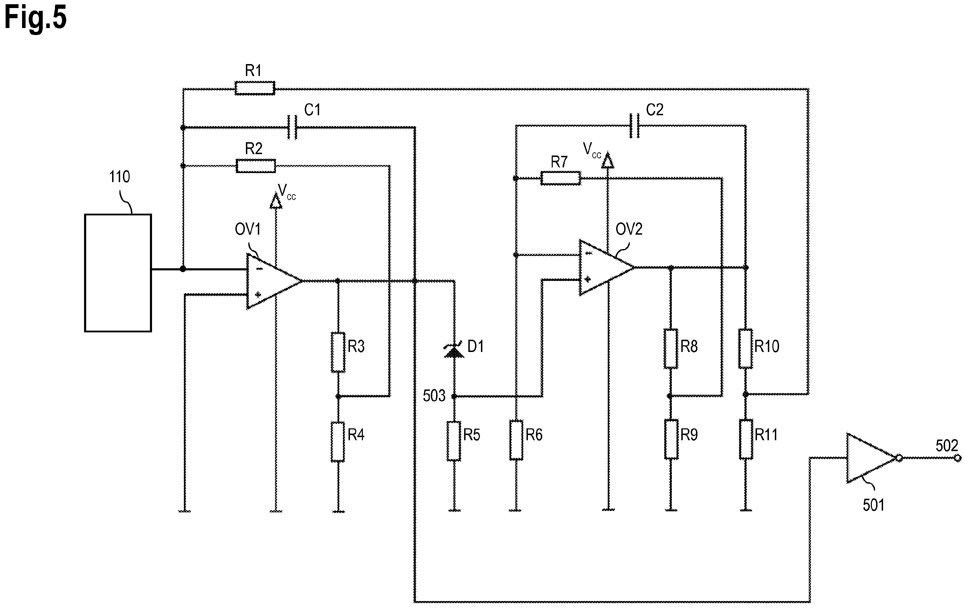

**Fig.5** zeigt ein Ausführungsbeispiel einer Schaltung für eine solche Auswertung mittels des erwähnten Balanceverstärkers.

Der in Fig.1 gezeigte Schaltungsblock 110 ist mit dem invertierenden Eingang eines Messverstärkers OV1 verbunden. Der nichtinvertierende Eingang des Messverstärkers OV1 liegt auf Masse. Der Ausgang des Messverstärkers OV1 ist über eine Reihenschaltung aus Widerständen R3 und R4 mit Masse verbunden, wobei der Mittenabgriff der Reihenschaltung über einen Widerstand R2 mit dem invertierenden Eingang des Messverstärkers OV1 verbunden ist. Weiterhin ist ein Kondensator C1 zwischen dem invertierenden Eingang und dem Ausgang des Messverstärkers OV1 angeordnet.

Der Ausgang des Messverstärkers OV1 ist mit der Kathode einer Zenerdiode D1 verbunden, die Anode der Zenerdiode D1 ist mit einem Knoten 503 verbunden. Der Knoten 503 ist über einen Widerstand R5 mit Masse verbunden. Weiterhin ist der Knoten 503 mit dem nichtinvertierenden Eingang eines Balanceverstärkers OV2 verbunden. Der invertierende Eingang des Balanceverstärkers OV2 ist über einen Widerstand R6 mit Masse verbunden. Der Ausgang des Balanceverstärkers OV2 ist über eine Reihenschaltung aus Widerständen R8 und R9 mit Masse verbunden, wobei der Mittenabgriff der Reihenschaltung über einen Widerstand R7 mit dem invertierenden Eingang des Balanceverstärkers OV2 verbunden ist. Weiterhin ist der Ausgang des Balanceverstärkers OV2 mit einer Reihenschaltung aus Widerständen R10 und R11 mit Masse verbunden, wobei der Mittenabgriff der Reihenschaltung über einen Widerstand R1 mit dem invertierenden Eingang des Messverstärkers OV1 verbunden ist. Weiterhin ist zwischen dem Ausgang und dem invertierenden Eingang des Balanceverstärkers OV2 ein Kondensator C2 angeordnet.

Beide Verstärker OV1, OV2 werden über die Versorgungsspannung V_{cc} betrieben und sind mit Masse verbunden. Der Ausgang des Messverstärkers OV1 stellt optional über einen Komparator 501 mit Hysterese ein Ausgangssignal 502 bereit.

Die Bauteile der Schaltungsanordnung gemäß Fig.5 könnten wie folgt dimensioniert oder gewählt sein: R1=R2=R3=R7=R8=R10=100k; R4=R5=1k; R6=22k; R9=R11=4,7k; C1=220pF; C2=2,2µF; D1=3,3V; OV1=OV2=LM2904; 501=74HC14.

Übersteigt die Ausgangsspannung des Messverstärkers OV1 die Referenzspannung, die durch die Zenerdiode D1 vorgegeben wird, fließt ein Strom durch die Zenerdiode D1 und den Widerstand R5. Dadurch steigt das Eingangssignal am nichtinvertierenden Eingang des Balanceverstärkers OV2 und damit dessen Ausgangsspannung. Dies geschieht solange, bis der in den invertierenden Eingang des Messverstärkers OV1 eingespeiste Strom das Ausgangssignal des Messverstärkers OV1 wieder absenkt und auf das Spannungsniveau der Referenzspannung bringt. Damit ist der Regelkreis geschlossen.

Um zu verhindern, dass die Regelung auch Schwankungen ausregelt, die auf der Aktivierung des berührungsempfindlichen Tasters beruhen, wird vorgeschlagen, den Balanceverstärker OV2 als Integrator mit einer wesentlich längeren Integrationszeit im Vergleich zu dem Messverstärker OV1 auszuführen.

Der Messverstärker OV1 reagiert fast trägheitslos auf die Berührung des Tasters, das Signal erscheint entsprechend seiner Verstärkung mit vollem Hub an seinem Ausgang. Der Balanceverstärker OV2 stellt mit vergleichsweise großer Verzögerung die Referenzspannung am Ausgang des Messverstärkers OV1 wieder her, auch wenn der Finger auf der Sensorfläche bleibt.

Zur Auswertung des durch die Berührung der Sensorfläche hervorgerufenen Signalhubs sollte die Integrationszeit des Balanceverstärkers OV2 länger sein als ein Einlesezyklus einer nachgeschalteten signalverarbeitenden Logik (z.B. eines Mikrokontrollers).

Auch ist es möglich, dass das Ausgangssignal mittels eines Flipflops gespeichert wird. Ein solches Flipflop könnte nach dem Einlesen von der signalverarbeitenden Logik mit einer Reset-Leitung zurückgesetzt werden. Dadurch kann der Tastenzustand solange gespeichert werden bis er zurückgesetzt wird.

Ist es erwünscht, die Dauer einer Tastenbetätigung zu erkennen, kann eine andere Eigenschaft der Anordnung genutzt werden: Entfernt sich der Finger von der Sensorfläche, so gibt es einen Überschwinger im Ausgangssignal des Messverstärkers OV1, da der Balanceverstärker OV2 auch hierfür eine Zeit zum Ausregeln benötigt.

In diesem Fall kann ein Komparator 501 mit einer Hysterese am Ausgang des den Messverstärkers OV1 vorgesehen sein, wobei die obere Schwelle des Komparators 501 oberhalb des Ruhepegels liegt. Wird die Sensorfläche berührt, geht das Signal des Messverstärkers OV1 unter die untere Hysterese-Schwelle des Komparators 501 und der Komparator 501 kippt und bleibt in dieser Stellung, da der Balanceverstärker nur bis zum Ruhepegel ausregelt. Erst wenn der Finger von der Sensorfläche genommen wird, wird durch den Überschwinger die obere Schaltschwelle des Komparators 501 überschritten und der Komparator 501 kippt in seinen Ruhezustand zurück. Dadurch kann der nachgeschaltete Mikrokontroller die Dauer der Tastenbetätigung erkennen.

Vorzugsweise ist der Komparator 501 zur Einstellung einer genauen Schwelle mittels eines Operationsverstärkers realisiert.

Ferner ist es von Vorteil, wenn die Rückkopplungswiderstände in Form von Spannungsteilern ausgeführt sind. Hierdurch lassen sich Werte vermeiden, die größer als 100 Kiloohm sind. Dies garantiert eine Stabilität der Schaltung auch unter Feuchtigkeitseinflüssen.

Auch ist es eine weitere Option das Tastenverhalten zu verbessern, um beispielsweise eine kürzere Erholzeit nach einer Tastenberührung zu erreichen. Hierzu wäre eine Schaltung vergleichbar mit einem Spitzenwertdetektor einsetzbar, jedoch mit umgekehrtem Verhalten. Die Schaltung hätte also dann in den beiden Schaltrichtungen verschiedene Integrationskonstanten.

### Weitere Vorteile:

Gemäß der hier vorgeschlagenen Lösung ist es möglich, dass parallel mehrere Tastenbetätigungen erfolgen. Bei der Auswertung der Berührtaster werden Einflüsse von parasitären Kapazitäten weitgehend kompensiert.

Zur Auswertung des Signals des Berührtasters ist kein Mikrokontroller notwendig.

Ein weiterer Vorteil ist es, dass schnell auf die Berührung des Sensors reagiert werden kann, da das Signal nicht durch Filteralgorithmen oder sonstige Verarbeitungsschritte eines Mikrokontrollers verzögert wird.

Die hohen Signalhübe ermöglichen eine gute Detektion der Berührung der Sensorfläche sowie ein digitales Ausgangssignal.

Auch ist es ein Vorteil, dass eine hohe Kanaltrennung ermöglicht wird. So können mehrere Berührtaster nebeneinander angeordnet werden, die sich nicht oder nur unwesentlich stören.

Der vorgeschlagene Ansatz ist robust gegen EMV-Störungen, insbesondere wenn integrierende Verstärker benutzt werden.

Auch ist die Lösung robust gegenüber hohe Leiterbahnwiderstände im Messzweig. So ist der Ansatz beispielsweise auch anwendbar bei auf Glas aufgebrachtem Indium-Zinn-Oxid, das einen hohen Flächenwiderstand aufweist.

Ein anderer Vorteil besteht darin, dass die Lösung robust gegenüber Schwankungen der Betriebsspannung sowie gegenüber Montagetoleranzen ist.

Eine Dicke der Isolationsschicht zwischen der Berührfläche und der Sensorfläche ist in einem großen Bereich wählbar.

Die Lösung stellt weiterhin effizient in einem Abgleich den Signalhub so ein, dass die Berührung der Sensorfläche mit großer Sicherheit detektiert werden kann. Insbesondere kann ein automatischer Abgleich eines high-Pegels des Berührtasters erfolgen.

Auch werden Toleranzen der eingesetzten Bauteile weitgehend kompensiert.

Eine Realisierungsvariante umfasst einen Balanceverstärker, der ein Grundsignal im Verhältnis zu einem konstanten high-Pegel einstellt; damit kann die Schaltung für einen großen Signalhub dimensioniert werden.

Die Schaltung erfordert keinen Schutzleiter. Dies ist von Vorteil bei einer mangelhaften Hausinstallation oder bei verschiedenen Erdungen der Person über Schuhsohlen bzw. Bodenbeschaffenheit.

### Bezugszeichenliste:

- 101: Sensorfläche
- 102: Sensorfläche
- 103: Steuerschaltung (z.B. Rechteckgenerator)
- 104: Ausgang des Messverstärkers 108
- 105: Knoten
- 106: Knoten
- 107: Eingang des Messverstärkers 108
- 108: Messverstärker
- 110: Schaltungsblock

- RB1: Leiterbahnwiderstand
- RB2: Leiterbahnwiderstand
- CS1: parasitäre Kapazität (Schalterkapazität)
- CP1: parasitäre Kapazität der Schaltung
- CS2: parasitäre Kapazität (Schalterkapazität)
- CP2: parasitäre Kapazität der Schaltung
- S1: Umschalter
- S2: Umschalter
- GND: Masse
- Uₐ: Ausgangsspannung des Messverstärkers 108
- V_{cc}: Versorgungsspannung
- C_{Vcc}: Kondensator zwischen V_{cc} und Masse

- 201: A/D-Wandler
- 202: Mikrokontroller
- 203: D/A-Wandler
- 204: Verbindung
- 205: Ausgangssignal

- 301: Komparator
- 302: Komparator
- 303: Mikrokontroller
- 304: Digitalpotenziometer
- 305: Verbindung
- 306: Ausgangssignal
- 401: Balanceverstärker
- 402: Referenz (z.B. Referenzspannung)
- 403: Verbindung
- 404: Ausgangssignal
- R1-R11: Widerstand
- C1-C2: Kondensator
- D1: Zenerdiode
- OV1: Verstärker (Messverstärker)
- OV2: Verstärker (Balanceverstärker)
- 501: Komparator
- 502: Ausgangssignal
- 503: Knoten

## Patentansprüche

1. Schaltungsanordnung, die als ein berührungsempfindlicher Taster ausgestaltet ist oder einen solchen umfasst,
- mit einer ersten Sensorfläche (101) und mit einer zweiten Sensorfläche (102), die nebeneinander auf einem Isolator angeordnet sind,
- wobei die erste Sensorfläche (101) mit einem Wechselsignal verbunden ist,
- wobei die zweite Sensorfläche (102) zumindest zeitweise mit einem Eingang (107) eines Messverstärkers (108) verbunden ist, wobei der Messverstärker (108, OV1) als ein Integrator ausgeführt ist,
- bei der ein Ausgang des Messverstärkers mit einem Balanceverstärker (401, OV2) verbunden ist,
- bei der der Balanceverstärker (401, OV2) als Referenzwert (402)eine Referenzspannung erhält, wobei anhand der Referenzspannung ein Schaltkriterium bestimmt ist derart, dass ein Übersteigen der Ausgangsspannung des Messverstärkers (OV1) über die Referenzspannung, die durch eine Zenerdiode (D1) vorgegeben wird, bedingt, dass ein Eingangssignal an einem nichtinvertierenden Eingang des Balanceverstärkers (OV2) und damit dessen Ausgangsspannung steigt, solange, bis ein in einen invertierenden Eingang des Messverstärkers (OV1) eingespeister Strom das Ausgangssignal des Messverstärkers (OV1) wieder absenkt und auf das Spannungsniveau der Referenzspannung bringt,
- bei der ein Ausgang des Balanceverstärkers (401, OV2) mit dem invertierenden Eingang (107) des Messverstärkers (108, OV1) rückgekoppelt ist,
- wobei der Balanceverstärker (401, OV2) als ein Integrator ausgeführt ist, der eine längere Integrationszeit aufweist als der Messverstärker (108, OV1),
- mit einem Schaltungsausgang, der zwischen dem Messverstärker (108, OV1) und dem Balanceverstärker (401, OV2) angeordnet ist.

2. Schaltungsanordnung nach Anspruch 1, bei der die zweite Sensorfläche (102) zumindest zeitweise schwebend, also ohne Massebezug, mit dem Eingang des Messverstärkers verbunden ist.

3. Schaltungsanordnung nach einem der vorhergehenden Ansprüche, bei der die erste Sensorfläche (101) abwechselnd mit einer Versorgungsspannung (V_{cc}) und mit Masse (GND) verbunden ist.

4. Schaltungsanordnung nach einem der vorhergehenden Ansprüche, bei der das Wechselsignal zur Umschaltung der ersten Sensorfläche mittels eines Rechteckgenerators (103) erzeugbar ist.

5. Schaltungsanordnung nach Anspruch 4, bei der der Rechteckgenerator (103) einen Umschalter (S2) steuert, der die Verbindung der zweiten Sensorfläche (102) umschaltet zwischen dem Eingang (107) des Messverstärkers (108) und Masse (GND).

6. Schaltungsanordnung nach einem der vorhergehenden Ansprüche, bei der die zweite Sensorfläche (102) über einen gesteuerten Schalter (S2) zumindest zeitweise mit dem Eingang des Messverstärkers verbunden ist, so dass entweder ein Ladestrom oder ein Entladestrom des die beiden Sensorflächen umfassenden Messkondensators an den Messverstärker geleitet wird.

7. Schaltungsanordnung nach einem der vorhergehenden Ansprüche, bei der der berührungsempfindliche Taster durch Berührung des Isolators oberhalb der beiden Sensorflächen aktivierbar ist.

8. Schaltungsanordnung nach einem der vorhergehenden Ansprüche, bei der die Sensorflächen mit einem Flachbandkabel angeschlossen sind, wobei zumindest zwischen zwei Anschlüssen der Sensorflächen mindestens eine Masseleitung vorgesehen ist.

9. Schaltungsanordnung nach einem der vorhergehenden Ansprüche, bei der eine Dauer der Betätigung des berührungsempfindlichen Tasters mittels eines Aktivierungssignals und eines Überschwingens im Ausgangssignal des Messverstärkers ermittelbar ist.

10. Schaltungsanordnung nach einem der vorhergehenden Ansprüche, bei der der berührungsempfindliche Taster in einem Haushaltsgerät, insbesondere einem Küchengerät, insbesondere einem Herd einsetzbar ist.

11. Haushaltsgerät mit mindestens einem berührungsempfindlichen Taster gemäß einem der vorhergehenden Ansprüche.

## Claims

1. Circuit arrangement which is configured as a touch-sensitive sensor or includes such a sensor,
- having a first sensor surface (101) and a second sensor surface (102) which are arranged side by side on an insulator,
- wherein the first sensor surface (101) is connected to an alternating signal,
- wherein the second sensor surface (102) is at least temporarily connected to an input (107) of a measuring amplifier (108), wherein the measuring amplifier (108, OV1) is designed as an integrator,
- wherein an output of the measuring amplifier is connected to a balance amplifier (401, OV2),
- wherein the balance amplifier (401, OV2) contains a reference voltage as a reference value (402), wherein on the basis of the reference voltage a switching criterion is determined such that if the output voltage of the measuring amplifier (OV1) exceeds the reference voltage defined by a Zener diode (D1) an input signal at a non-inverting input of the balance amplifier (OV2) and thus its output voltage increases, until a current fed into an inverting input of the measuring amplifier (OV1) again reduces the output signal of the measuring amplifier (OV1) and brings it to the voltage level of the reference voltage,
- wherein the one output of the balance amplifier (401, OV2) is coupled back with the inverting input (107) of the measuring amplifier (108, OV 1),
- wherein the balance amplifier (401, OV1) is designed as an integrator which has a longer integration time than the measuring amplifier (108, OV1),
- having a circuit output which is arranged between the measuring amplifier (108, OV1) and the balance amplifier (401, OV2).

2. Circuit arrangement according to claim 1, wherein the second sensor surface (102) is at least temporarily connected in a floating manner, i.e. without reference to earth, to the input of the measuring amplifier.

3. Circuit arrangement according to one of the preceding claims, wherein the first sensor surface (101) is connected alternately to a supply voltage (V_{cc}) and to earth (GND).

4. Circuit arrangement according to one of the preceding claims, wherein the alternating signal can be generated to switch the first sensor surface by means of a square-wave generator (103).

5. Circuit arrangement according to claim 4, wherein the square-wave generator (103) controls a switch (S2) which switches the connection of the second sensor surface (102) between the input (107) of the measuring amplifier (108) and earth (GND).

6. Circuit arrangement according to one of the preceding claims, wherein the second sensor surface (102) is connected at least temporarily via a controlled switch (S2) to the input of the measuring amplifier, so that either a charge current or a discharge current of the measuring capacitor comprising the two sensor surfaces is conducted to the measuring amplifier.

7. Circuit arrangement according to one of the preceding claims, wherein the touch-sensitive sensor can be actuated by touching the insulator above the two sensor surfaces.

8. Circuit arrangement according to one of the preceding claims, wherein the sensor surfaces are connected to a flat ribbon cable, wherein at least one earth line is provided at least between two terminals of the sensor surfaces.

9. Circuit arrangement according to one of the preceding claims, wherein a duration of the actuation of the touch-sensitive sensor can be determined by means of an activation signal and an overshoot in the output signal of the measuring amplifier.

10. Circuit arrangement according to one of the preceding claims, wherein the touch-sensitive sensor can be used in a household appliance, in particular a kitchen appliance, in particular a cooker.

11. Household appliance having at least one touch sensitive switch according to one of the preceding claims.

## Revendications

1. Agencement de circuit qui est réalisé en tant qu'un bouton tactile ou comprend un tel bouton tactile,
- comprenant une première surface de capteur (101) et une deuxième surface de capteur (102) qui sont disposées l'une à côté de l'autre sur un isolateur,
- la première surface de capteur (101) étant reliée à un signal alternatif,
- la deuxième surface de capteur (102) étant reliée au moins temporairement à une entrée (107) d'un amplificateur de mesure (108), l'amplificateur de mesure (108, OV1) étant réalisé en tant qu'un intégrateur,
- dans lequel agencement de circuit une sortie de l'amplificateur de mesure est relié à un amplificateur de balance (401, OV2),
- dans lequel l'amplificateur de balance (401, OV2) reçoit une tension de référence en tant que valeur de référence (402), un critère de commutation étant déterminé à l'aide de la tension de référence de manière à ce qu'un dépassement de la tension de sortie de l'amplificateur de mesure (OV1) au-delà de la tension de référence prédéfinie par une diode zener implique qu'un signal d'entrée sur une entrée non inverseuse de l'amplificateur de balance (OV2) augmente, et par conséquent la tension de sortie de celui-ci, jusqu'à ce qu'un courant alimenté dans une entrée inverseuse de l'amplificateur de mesure (OV1) baisse de nouveau le signal de sortie de l'amplificateur de mesure (OV1) et l'amène au niveau de tension de la tension de référence,
- dans lequel une sortie de l'amplificateur de balance (401, OV2) est couplée en retour à l'entrée inverseuse (107) de l'amplificateur de mesure (108, OV1),
- l'amplificateur de balance (401, OV2) étant réalisé en tant qu'un intégrateur qui présente un temps d'intégration plus long que l'amplificateur de mesure (108, OV1),
- comprenant une sortie de circuit qui est disposée entre l'amplificateur de mesure (108, OV1) et l'amplificateur de balance (401, OV2).

2. Agencement de circuit selon la revendication 1, dans lequel la deuxième surface de capteur (102) est reliée au moins temporairement de manière flottante, donc sans référence à la masse, à l'entrée de l'amplificateur de mesure.

3. Agencement de circuit selon l'une quelconque des revendications précédentes, dans lequel la première surface de capteur (101) est reliée en alternance à une tension d'alimentation (V_{cc}) et à la masse (GND).

4. Agencement de circuit selon l'une quelconque des revendications précédentes, dans lequel le signal alternatif peut être généré pour la commutation de la première surface de capteur au moyen d'un générateur de signaux rectangulaires (103).

5. Agencement de circuit selon la revendication 4, dans lequel le générateur de signaux rectangulaires (103) commande un commutateur (S2) qui commute la liaison de la deuxième surface de capteur (102) entre l'entrée (107) de l'amplificateur de mesure (108) et la masse (GND).

6. Agencement de circuit selon l'une quelconque des revendications précédentes, dans lequel la deuxième surface de capteur (102) est reliée au moins temporairement à l'entrée de l'amplificateur de mesure par l'intermédiaire d'un commutateur commandé (S2), de sorte que soit un courant de charge soit un courant de décharge du condensateur de mesure comprenant les deux surfaces de capteur est amené à l'amplificateur de mesure.

7. Agencement de circuit selon l'une quelconque des revendications précédentes, dans lequel le bouton tactile est activable en touchant l'isolateur au-dessus des deux surfaces de capteur.

8. Agencement de circuit selon l'une quelconque des revendications précédentes, dans lequel les surfaces de capteur sont raccordées par un câble plat, au moins une ligne de masse étant ménagée au moins entre deux raccords des surfaces de capteur.

9. Agencement de circuit selon l'une quelconque des revendications précédentes, dans lequel une durée de l'activation du bouton tactile peut être déterminée au moyen d'un signal d'activation et d'une suroscillation dans le signal de sortie de l'amplificateur de mesure.

10. Agencement de circuit selon l'une quelconque des revendications précédentes, dans lequel le bouton tactile peut être utilisé dans un appareil ménager, notamment un appareil de cuisine, notamment une cuisinière.

11. Appareil ménager comprenant au moins un bouton tactile selon l'une quelconque des revendications précédentes.
